(19) Europäisches Patentamt
European Patent Office
Office européen des brevets

(11) **EP 2 826 069 B1**

## (12) EUROPÄISCHE PATENTSCHRIFT

(45) Veröffentlichungstag und Bekanntmachung des Hinweises auf die Patenterteilung:
**17.02.2016 Patentblatt 2016/07**

(21) Anmeldenummer: **13716183.2**

(22) Anmeldetag: **09.03.2013**

(51) Int Cl.:
*H01L 29/51* (2006.01)  *G01L 9/00* (2006.01)
*G01L 1/12* (2006.01)  *G01N 3/08* (2006.01)
*H01L 41/113* (2006.01)

(86) Internationale Anmeldenummer:
**PCT/DE2013/000134**

(87) Internationale Veröffentlichungsnummer:
**WO 2013/135226 (19.09.2013 Gazette 2013/38)**

(54) **SENSORANORDNUNG AUS TRÄGERSUBSTRAT UND FERROELEKTRISCHER SCHICHT SOWIE VERFAHREN ZUR HERSTELLUNG UND VERWENDUNG DER SENSORANORDNUNG**

SENSOR ARRANGEMENT COMPRISING A CARRIER SUBSTRATE AND A FERROELECTRIC LAYER AND METHOD FOR PRODUCING AND USING THE SENSOR ARRANGEMENT

ENSEMBLE DE DÉTECTION CONSTITUÉ D'UN SUBSTRAT SUPPORT ET D'UNE COUCHE FERROÉLECTRIQUE, AINSI QUE PROCÉDÉ DE FABRICATION ET UTILISATION DUDIT ENSEMBLE DE DÉTECTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.03.2012 DE 102012005262**

(43) Veröffentlichungstag der Anmeldung:
**21.01.2015 Patentblatt 2015/04**

(73) Patentinhaber: **Forschungszentrum Jülich GmbH 52425 Jülich (DE)**

(72) Erfinder: **WÖRDENWEBER, Roger 52382 Niederzier (DE)**

(56) Entgegenhaltungen:
**EP-A2- 0 661 754  US-B1- 7 808 236**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**EP 2 826 069 B1**

**Beschreibung**

Die Erfindung betrifft eine Sensoranordnung aus Trägersubstrat und ferroelektrischer Schicht sowie ein Verfahren zur Herstellung und Verwendung der Anordnung.

Es ist bekannt, dass sich in einem isolierenden, polarisierbaren Material, einem sogenannten Dielektrikum, durch ein äußeres elektrisches Feld E ($Vm^{-1}$) eine Polarisation Pi ($Asm^{-2}$) induzieren lässt. Unter den Dielektrika bewirkt in piezoelektrischen Materialien zusätzlich zu externen elektrischen Feldern auch eine durch Druck, Zug oder Torsion verursachte äußere mechanische Deformation eine Ladungsverschiebung und somit eine elektrische Polarisation des Materials. Dabei werden die positiven und negativen Gitterbausteine durch die Deformation so verschoben, dass ein elektrisches Dipolmoment entsteht, wodurch scheinbare Ladungen an der Oberfläche des nach außen hin neutralen Kristalls induziert werden. Unter dem Begriff Pyroelektrizität werden jene Materialien der Piezoelektrika zusammengefasst, die auch in Abwesenheit eines äußeren elektrischen Feldes elektrische Dipolmomente besitzen, die auf Basis von Verzerrungen im Kristallgitter und damit einhergehender Verschiebung von Ladungsschwerpunkten hervorgerufen werden, und die somit eine elektrische Polarisation des Kristalls bewirken. Diese Stoffe sind demnach bereits ohne ein elektrisches Feld spontan polarisiert. Unter dem Begriff Ferroelektrizität werden schließlich jene Stoffe mit einem elektrischen Dipolmoment zusammengefasst, die durch Anlegen eines äußeren elektrischen Feldes die Richtung der spontanen Polarisation ändern. Oberhalb der materialabhängigen Curie-Temperatur verschwindet das Phänomen, und das Material geht in den paraelektrischen Zustand über. Dieser Übergang ist reversibel, das heißt bei Unterschreiten der Curie-Temperatur findet ein Phasenübergang mit einer Strukturveränderung statt und das Material geht erneut in den ferroelektrischen Zustand über. Üblicherweise ist die Permittivität, also auch die Änderung der Permittivität, mit der Temperatur im Bereich des Überganges am größten. Eine reversible, möglichst große Änderung der Permittivität wird daher im Temperaturbereich direkt oberhalb des Phasenüberganges erreicht.

Die Mehrzahl der Ferroelektrika sind Oxide. Bekannteste Ferroelektrika sind die Ionenkristalle mit Perowskit-Struktur, wie z. B. $BaTiO_3$. Einige Materialien zeigen lediglich in dünnen Schichten ferroelektrische Eigenschaften, z. B. $SrTiO_3$. Ferroelektrische Schichten werden im Wesentlichen in integrierten Schaltungen und in der Mobilfunktechnologie verwendet.

Aus neueren Entwicklungen zu Ferroelektrika (R. Wördenweber, E. Hollmann, R. Ott, T. Hürtgen, Kai Keong Lee (2009). Improved ferroelectricity of strained SrTiO3 thin films on sapphire. J Electroceram 22:363-368) ist es bekannt, dünne Filme aus ferroelektrischem $SrTiO_3$ (STO) durch epitaktisches Wachstum und Übernahme der Gitterparameter zum Beispiel auf $CeO_2$ gepuffertem Saphir zu verspannen. Die dielektrischen Eigenschaften des verspannten STO wurden durch eine Kapazität auf der Schicht ermittelt.

Aus der Europäischen Patentanmeldung EP-0661754 sind Ferroelektrika bestehend aus einer auf einem Substrat aufgebrachten kristallinen Schicht bekannt. Das Dokument erwähnt auch die Möglichkeit der Anwendung solcher Ferroelektrika als pyroelektrische Infrarotsensoren.

Das Arbeitsprinzip von Druck- und Biegesensoren beruht üblicherweise auf der Umsetzung des zu messenden Parameters in ein elektrisches Signal. Dies kann direkt oder indirekt geschehen. Druck- und Biegesensoren können zur direkten Messung des Drucks bzw. der Durchbiegung und zur indirekten Bestimmung anderer Parameter, wie z. B. der Temperatur, des Flow oder der Position verwendet werden.

Abhängig von der Anwendung, der gewünschten Messgenauigkeit und den Kosten werden z. B. (Piezo-)resistive Sensoren, piezoelektrische Sensoren, induktive Sensoren, kapazitive Sensoren und optische Sensoren eingesetzt. Oft kommen Kombinationen dieser Sensoren zur Anwendung, wie zum Beispiel in einer Golay-Zelle.

Ein piezoelektrischer Drucksensor zeichnet sich dadurch aus, dass in dem Kristall mit polaren Achsen mittels des zu messenden Drucks eine Ladungstrennung induziert wird, die eine elektrische Spannung erzeugt. Dieser auch als piezoelektrischer Effekt bekannte Zustand bewirkt somit, dass sich durch den Druck im Inneren des Kristalls Ionen verschieben, die an der Oberfläche eine elektrische Ladung proportional zur mechanisch ausgeübten Kraft ausbildet. Die Ladung wird in eine hierzu proportionale elektrische Spannung umgeformt, z. B. mittels eines Verstärkers. Bei piezoresistiven Sensoren hingegen verändert sich der spezifische Widerstand der Materialien solange sie einer Zug- oder Druckbelastung ausgesetzt werden. Dieser Effekt tritt auch an Kristallen ohne eine polare Achse auf, z. B. in Halbleitern, wie Silizium.

Ein generelles Problem piezoelektrischer Drucksensoren und der in Dehnungsmessstreifen eingesetzten piezoresistiven Sensoranordnungen ist, dass diese vergleichsweise komplex aufgebaut und damit kostspielig sind. Die Empfindlichkeit dieser Sensoren ist ebenfalls steigerungsbedürftig.

Nachteilig ist ferner, dass die Pyroelektrizität oftmals störende Artefakte im technisch relevanten Anwendungsbereich verursacht, welche den eigentlich interessanten piezoelektrischen Effekten überlagert sind. Drucksensoren aus pyroelektrischen Materialien können falsch positive Signale anzeigen, da unter Erwärmung Signale auftreten, obwohl gar keine Druckänderung vorliegt.

Aufgabe und Lösung der Erfindung

Aufgabe der Erfindung ist es eine Sensoranordnung bereit zu stellen, die eine im Vergleich zu piezoelektrischen und pyroelektrischen Sensoren aus dem Stand der Technik gesteigerte Sensibilität und Sensitivität aufweist und dabei besonders einfach und kostengünstig herzustellen ist.

Eine weitere Aufgabe der Erfindung ist es, ein Verfahren zur Herstellung der Sensoranordnung und deren Verwendung anzugeben.

Die Aufgabe wird durch die Sensoranordnung nach Patentanspruch 1 und dem Verfahren zu seiner Herstellung sowie deren Verwendung gemäß den Nebenansprüchen gelöst. Vorteilhafte Ausgestaltungen hierzu ergeben sich jeweils gegebenenfalls aus den hierauf rückbezogenen Patentansprüchen.

Beschreibung der Erfindung

Die Sensoranordnung besteht aus einem Trägersubstrat sowie einer auf dem Trägersubstrat angeordneten Schicht. Die ferroelektrische Schicht kann ganzflächig auf dem Trägersubstrat angeordnet sein, oder lediglich am Rand vom Trägersubstrat getragen werden. Auf der ferroelektrischen Schicht kann eine Kondensatoranordnung als ein Mittel zur Auslese der Permittivität der ferroelektrischen Schicht angeordnet sein. Diese dient der Auslese der elektrischen Eigenschaften der Schicht auf Grund eines normal auf die ferroelektrische Schicht ausgeübten Überdrucks oder Unterdrucks.

Alternativ können die elektronischen Eigenschaften berührungsfrei mittels optischer Messungen, z. B. durch Ellipsometrie, ausgelesen werden. In diesem Fall ist es möglich, dass die ferroelektrische Schicht lediglich am Rand durch das Trägersubstrat gestützt wird.

Die ferroelektrische Schicht ist kristallin ausgebildet. Sofern die Schicht ganzflächig auf dem Trägersubstrat angeordnet ist, ist es von Bedeutung, dass das Trägersubstrat flexibel auf einen geringfügig auf die Sensoranordnung wirkenden Druck reagiert und ausgelenkt wird. Die Dicke des Trägersubstrats soll dabei zwischen 1-500 $\mu$m aufweisen.

Ein auf die Sensoranordnung ausgeübter Druck führt zu einer Kompression oder zu einer Dehnung der ferroelektrischen Schicht und des Trägersubstrats, welche zu einer nachweisbaren Änderung der Permittivität führt. Die ferroelektrische Schicht weist bei Raumtemperatur eine zentrosymmetrische Ausrichtung des Kristalls auf dem Substrat auf, bzw. nimmt diese Ausrichtung von sich aus an, das heißt die Schicht befindet sich im dielektrischen Zustand. Die Dicke der ferroelektrischen Schicht soll etwa 1-1000 nm betragen.

Die Anordnung zur Auslese der Permittivität weist einen normal auf die ferroelektrische Schicht wirkenden mechanischen Druck durch Änderung der Polarisierbarkeit des ferroelektrischen Materials nach, die auf Grund des Übergangs vom zentrosymmetrischen in einen nicht-zentrosymmetrischen Gitterzustand des Materials der Schicht auftritt. Je nach Anordnung der ferroelektrischen Schicht auf dem Trägersubstrat sowie der Anordnung der Ausleseanordnung auf der ferroelektrischen Schicht und des Trägersubstrats, führt der ausgeübte Druck zu einer Kompression oder zu einer Dehnung der ferroelektrischen Schicht.

Die erfindungsgemäße Sensoranordnung basiert somit auf der Änderung der Polarisierbarkeit und damit der Permittivität ferroelektrischer Kristalle bei Änderung der Kristallstruktur durch Druckanwendung. Im Gegensatz zum piezoelektrischen Sensor liegt dem Prinzip also nicht die Verschiebung der Ladungen "positive gegenüber negative" zugrunde, sondern die Polarisierbarkeit von Kristallen. Zentrosymmetrische Kristalle, welche üblicherweise nicht ferroelektrisch sind und nur eine kleine Permittivität aufweisen, werden durch die Verformung zu nicht-zentrosymmetrischen Kristallen verändert. Dies führt zu einer extremen Erhöhung der Polarisierbarkeit (Permittivität) bis hin zu einer induzierten Ferroelektrizität. Änderungen der Permittivität um mehr als eine Größenordnung bei Änderung eines Kristallgitterparameters um < 1 % sind dabei erreichbar. Dies bewirkt vorteilhaft, dass die Sensoranordnung eine extrem hohe Empfindlichkeit bzw. Sensibilität aufweist. Die Änderung der Permittivität kann nun sehr leicht kapazitiv oder berührungsfrei optisch ausgelesen werden. Die Sensoranordnung liest mechanische Kräfte auf Basis der sich ändernden Polarisierbarkeit der ferroelektrischen Schicht aus. Falsch positive Ereignisse treten dabei anders als bei den pyroelektrischen Materialien faktisch nicht auf.

Im Rahmen der Erfindung wurde überraschend gefunden, dass nicht nur eine epitaktisch aufgewachsene Schicht durch mechanische Verspannung auf einem seitens der Gitterparameter abweichenden Substrat zu einer Polarisierbarkeit der ferroelektrischen Schicht führt. Vielmehr wurde erkannt, dass auch ein technisch relevanter, geringfügiger Druck bzw. Zug auf die Sensoranordnung zu einer deutlichen Permittivitätsänderung der ferroelektrischen Schicht führen kann.

Da bei geeigneter Auswahl der ferroelektrischen Schicht schon Bruchteile einer Änderung der Gitterkonstante, beispielsweise von $10^{-4}$ %, zu einer messbaren Veränderung der Permittivität führen, wird die Aufgabe allein dadurch bereits gelöst, dass eine kristalline ferroelektrische Schicht auf dem Trägersubstrat bereit gestellt wird, dessen Permittivität z. B. mit einem Ellipsometer ausgelesen wird. Der Strahlengang des Ellipsometers ist auf die ferroelektrische Schicht gerichtet und weist die Änderung der Permittivität nach.

Wie erwähnt, kann die ferroelektrische Schicht auf einer dünnen Membrane als Trägersubstrat abgeschieden sein. Mittels der nachgewiesenen Veränderung der Permittivität der ferroelektrischen Schicht als Sensorschicht werden vorteilhaft Drücke im Pa-Bereich detektierbar. Selbstverständlich kann auch bei Verwendung einer optischen Ausleseeinheit die ferroelektrische Schicht ganzflächig auf dem Trägersubstrat angeordnet sein, z. B. aus Gründen der Stabilität.

In einer Ausgestaltung der Erfindung wird ein flexibles folienartiges Trägersubstrat aus kristallinem Material, wie z. B. aus Silizium oder $Al_2O_3$, oder ein Metall oder ein organisches Material, wie z. B. ein Polyimid als Trägersubstrat verwendet. Die Auswahl des Trägermaterials hängt von der jeweiligen Anwendung und den Anforderungen der Sensorschicht ab. Durch die Verwendung von Folien ist ein hohes Maß an Verspannung gewährleistet.

Das ferroelektrische Material besteht vorzugsweise aus $CaTiO_3$, $SrTiO_3$, $KTaO_3$, $BaTiO_3$, $Pb_5GeO_{11}$, $Eu_2(MoO_4)_3$, $PbTa_2O_6$, $KNbO_3$, $SrTeO_3$, $PbTiO_3$, $SrBi_2Ta_2O_9$, $LiTaO_3$, $LiNbO_3$ oder einer Kombination hieraus. Eine Liste an möglichen Ferroelektrika hieraus ist in Tabelle 1 gezeigt. Die jeweilige Übergangstemperatur (Curie-Temperatur) ist angegeben.

Tabelle 1: Ferroelektrische Verbindungen
und deren Übergangstemperatur.

| Verbindung | $T_c$ [K] |
|---|---|
| $CaTiO_3$ | (-84) |
| $SrTiO_3$ | (0 - 44) durch Verspannung induzierter Phasenübergang 20-40 K bis Raumtemperatur |
| $KTaO_3$ | 2,8 |
| $BaTiO_3$ | 396 (Kompression) |
| $Pb_5GeO_{11}$ | 451 |
| $Eu_2(MoO_4)_3$ | 453 |
| $PbTa_2O_6$ | 533 |
| $KNbO_3$ | 708 |
| $SrTeO_3$ | 758 |
| $PbTiO_3$ | 763 |
| $SrBi_2Ta_2O_9$ | 843 |
| $LiTaO_3$ | 938 |
| $LiNbO_3$ | 1483 |

Legierungen aus diesen Materialien (z. B. $(Ca,Sr)TiO_3$ oder $(Ba,Sr)TiO_3$) als auch dotierte Oxyde dieser Reihe sind ebenfalls mögliche Kandidaten zum Aufbau der ferroelektrischen Schicht. Dadurch wird vorteilhaft bewirkt, dass eine Schicht oder sogar ein Schichtsystem ausgewählt werden kann, das optimal zur jeweiligen Anwendung passt.

Besonders vorteilhaft wird eine ferroelektrische Schicht aus einem Material mit einer Übergangstemperatur kleiner der Raumtemperatur derartig auf dem Trägersubstrat angeordnet, dass sich ein Druck zu einer Zugspannung in der Richtung des Kristallgitters auswirkt, in der die elektrische Polarisierung des Kristalles gemessen wird. Dadurch wird vorteilhaft bewirkt, dass die Übergangstemperatur in der Kristallrichtung erhöht wird, was gleichzeitig zu einer Erhöhung der Permittivität bei Raumtemperatur in der Kristallrichtung führt. Da die Permittivität im Bereich vor Einsetzen des Überganges zur Ferroelektrizität extrem stark ansteigt, entsteht auf diese Weise vorteilhaft ein extrem empfindlicher Sensor.

Es kann auch ein ferroelektrisches Material mit einer Übergangstemperatur größer der Raumtemperatur derartig auf dem Trägersubstrat angeordnet sein, dass sich ein Druck zu einer Druckspannung in der Richtung des Kristallgitters auswirkt, in der die elektrische Polarisierung des Kristalles gemessen wird. Dadurch wird vorteilhaft bewirkt, dass die Übergangstemperatur in der Kristallrichtung reduziert wird. In Analogie kann so wiederum der Bereich extrem großer Druckabhängigkeit der Permittivität im Übergangsbereich ausgenutzt werden.

Somit lassen sich unterschiedliche Fälle unterscheiden, die in Tabelle 2 für die Anordnungen vertikaler als auch planarer kapazitiver Messvorrichtungen an einer Membran mit ferroelektrischer Schicht, auf die ein Druck auf der beschichteten Seite wirkt, aufgelistet werden:

Tabelle 2: Fallbeispiele für eine Anordnung Membran mit ferroelektrischer Schicht mit vertikaler bzw. planarer Kapazitätsauslesung und einem von der mit dem Ferroelektrikum beschichteten Seite angreifenden Druck (D > 0) bzw. Zug (D < 0). Die Änderung der Permittivität ist beschrieben für die Fälle, dass die Übergangstemperatur $T_c$ der ferroelektrischen Schicht unterhalb bzw. oberhalb der Raumtemperatur (RT) liegt.

| | | Vertikale Kapazität | Planare Kapazität |
|---|---|---|---|
| $T_c$ < RT | D > 0 | $\varepsilon$ nimmt stark zu (sehr vorteilhaft) | $\varepsilon$ nimmt ab |
| | D < 0 | $\varepsilon$ nimmt ab | $\varepsilon$ nimmt stark zu (sehr vorteilhaft) |
| $T_c$ > RT | D > 0 | $\varepsilon$ nimmt ab | $\varepsilon$ nimmt stark zu (sehr vorteilhaft) |
| | D < 0 | $\varepsilon$ nimmt stark zu (sehr vorteilhaft) | $\varepsilon$ nimmt ab |

Die Sensoranordnung weist besonders vorteilhaft ein ferroelektrisches Material mit einer Übergangstemperatur größer als der Raumtemperatur auf einer Seite des Trägersubstrats und ein ferroelektrisches Material mit einer Übergangstemperatur kleiner der Raumtemperatur auf der gegenüberliegenden Seite des Trägersubstrats auf. Dadurch wird vorteilhaft bewirkt, dass sowohl Druck- als auch Zugspannungen mit hoher Empfindlichkeit detektiert werden können.

Ein Verfahren zur Herstellung der erfindungsgemäßen Sensoranordnung sieht vor, dass ein ferroelektrisches Material kristallin durch PVD (Physical Vapour Deposition), CVD (Chemical Vapour Deposition) oder anderen Abscheideverfahren (CSD (Chemical Solution Deposition), EPD (Elektrophoretische Abscheidung), o.a.) auf dem Trägersubstrat angeordnet wird und auf das ferroelektrische Material mindestens eine Kondensatoranordnung angeordnet wird, die die ausgeübte mechanische Kraft durch Änderung der Permittivität der mechanisch verformten Schicht nachweist. Alternativ kann die Permittivität kontaktlos, z. B. optisch über Ellipsometrie, ausgelesen werden.

Vorteilhaft werden die beschriebenen Sensoranordnungen als Druck oder Biegesensoren eingesetzt. In einem Druck- oder Biegesensor wird auf die Sensoranordnung mechanische Kraft ausgeübt. Diese führt reversibel zu einer Änderung der Polarisierbarkeit in der ferroelektrischen Schicht und wird entsprechend der Kondensatoranordnung oder kontaktlos ausgelesen. Nach dem Abklingen der Kraft wird die Polarisierbarkeit der ferroelektrischen Schicht wieder in den Ausgangszustand überführt.

Die erfindungsgemäßen Sensoren sind besonders vorteilhaft in folgenden Anwendungsgebieten einsetzbar:

Als Biege- und Dehnungssensoren mit extrem hoher Empfindlichkeit, zur Messung des Absolutwertes der Biegung- bzw. Dehnung sowie richtungsabhängiger und lokaler Messung der Biegung- bzw. Dehnung bei einfacher elektronischer Auslese. Einsatzgebiet sind die Druckmessung, die Überdruckkontrolle oder (Durch-)Flussmessungen von Gasen oder Flüssigkeiten; Positionsbestimmung und Positionierer, in Touchscreens, bei analoge Messumformung (z. B. Temperaturmessung in einer Golay-Zelle) sowie als Schalter, z. B. bei Auslösung von Sicherheitssystemen wie Airbags bis hin zu intelligenten Schaltungen.

Spezieller Beschreibungsteil

Es zeigen:

Figur 1: Prinzip der erfindungsgemäßen Sensoranordnung.
Figur 2: Schematische Abbildung (Schnitt) erfindungsgemäßer Sensoranordnungen aus Trägersubstrat und ferroelektrischer Schicht mit optischer Auslese.
Figur 3: Schematische Abbildung (Schnitt) erfindungsgemäßer Sensoranordnungen aus Trägersubstrat und ferroelektrischer Schicht mit kapazitiver Auslese.
Figur 4: a, b: Aufsicht unterschiedlicher kapazitiver Auslesekapazitäten.

Dieselben Bezugszeichen in den Figuren weisen auf identische Bauteile hin.

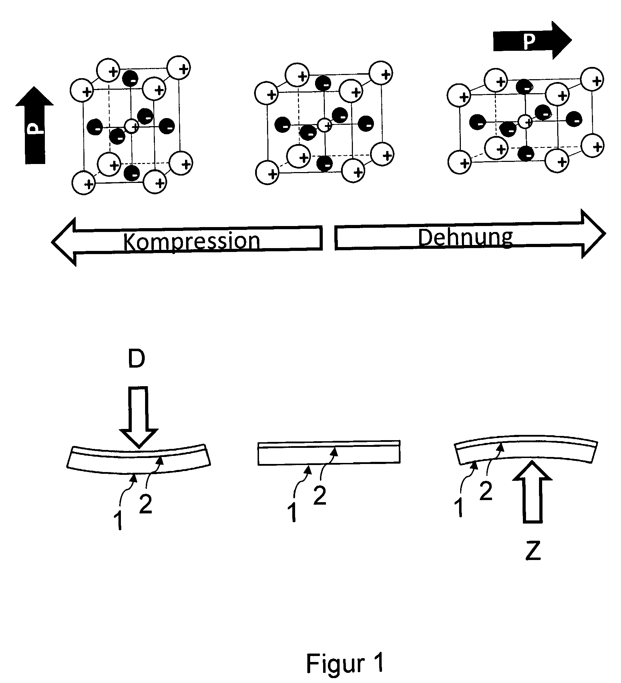

In Figur 1 ist das erfindungsgemäße Prinzip der Sensoranordnung dargestellt. Die Polarisierbarkeit ist ein Maß für die Verschiebbarkeit von positiver relativ zu negativer Ladung beim Anlegen eines äußeren elektrischen Feldes. Je höher also die Polarisierbarkeit ist, desto leichter lässt sich ein Dipolmoment durch ein elektrisches Feld induzieren. Die Polarisierbarkeit setzt sich aus einem elektrischen (Verschiebung der Elektronenwolke relativ zu den Kernen) und einem ionischen Anteil (Verschiebung von positiven Ionen relativ zu negativen Ionen) zusammen. Die ionische Polarisierbarkeit liefert die größten Beiträge zur Permittivität. Außerdem hängt der ionische Beitrag stark von der Kristallstruktur, insbesondere der Kristallsymmetrie, ab. Es gilt generell, dass zentrosymmetrische Kristalle nicht ferroelektrisch sein können (Figur 1, Mitte).

Erfindungsgemäß wird durch Druck (uniaxial oder biaxial) die Kristallstruktur und auch die Kristallsymmetrie verändert, siehe Figur 1, links und rechts der Mitte. Dies bewirkt eine Veränderung der Polarisierbarkeit P der Kristalle. Die größte Veränderung ist erfindungsgemäß zu erwarten, wenn aus der zentrosymmetrischen (Mitte) eine nicht-zentrosymmetrische Struktur (links und rechts der Mitte) entsteht. Hier entsteht durch Gitterverzerrung aus einem dielektrischen ein ferroelektrischer Zustand. Dies bewirkt enorme Veränderungen der Permittivität. Im Falle von epitaktischen, einkristallinen Schichten ist vom Erfinder in einem Perowskit ($ABO_3$ -Struktur) eine Steigerung von $\varepsilon \approx 300$ auf $\varepsilon > 5000$ bei einer Veränderung der Gitterkonstante von nur etwa 1% gemessen worden. Es ist die erfindungsgemäße Annahme der Erfindung, dass ähnliche Modifikationen der Permittivität auch mechanisch bei Druckänderungen im Pa-Bereich erreicht werden können. Der untere Teil der Figur zeigt jeweils eine Anordnung der Schicht auf dem Träger für die unterschiedlichen Zustände. Dabei ist auf dem Trägersubstrat 1 die ferroelektrische Schicht 2 angeordnet. Der dicke Pfeil links und rechts in der Figur 1 unten gibt den auf die Anordnung einwirkenden Überdruck D (links) bzw. Unterdruck D (rechts) an. Je nach Anordnung der ferroelektrischen Schicht resultiert daraus eine Kompression bzw. Dehnung der Kristallstruktur in der Schichtebene. Diese Kompression bzw. Dehnung wird dann durch die gegenteilige Dehnung bzw. Kompression senkrecht zur Schichtebene teilweise kompensiert. Durch zusätzliche Anordnung der Schicht unter dem Träger kann der Effekt genau umgekehrt verlaufen.

Generell gilt, dass ein Druck positiv bzw. negativ normal zur Membran - eine Kompression bzw. Dehnung in der Schichtebene der ferroelektrischen Schicht mit gleichzeitiger Kompensation normal zur Schichtebene bewirkt.

P im oberen Teil der Figur 1 gibt die Richtung der Polarisierbarkeit des Kristalls an, wenn wie im unteren Teil gezeigt, ein Über- oder Unterdruck auf die ferroelektrische Schicht einwirkt.

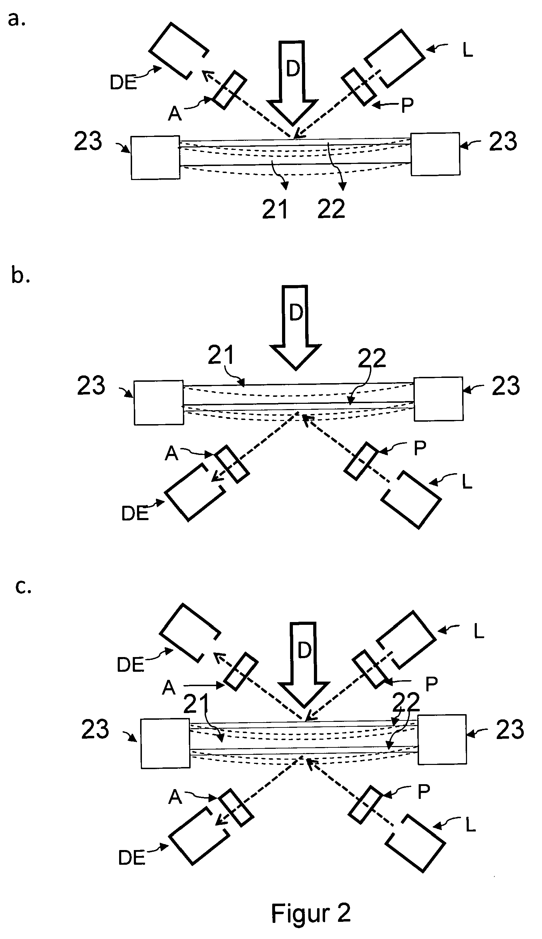

Figur 2 zeigt den Drucksensor mit optischer Auslesung (Ellipsometrie) bestehend aus Lichtquelle L, Polarisator P, Analysator A und Detektor DE. Folgende Fälle sind gezeigt:

a) Ferroelektrische Schicht auf der dem Druck (D>0) zugewandten Seite der Membran. Alternativ kann die Membran entfallen und die ferroelektrische Schicht als Membran ausgebildet sein.

b) Ferroelektrische Schicht unter der dem Druck (D>0) zugewandten Seite der Membran. Alternativ kann die Membran entfallen und die ferroelektrische Schicht als Membran ausgebildet sein.

c) Doppelseitig mit einer ferroelektrischen Sensorschicht beschichtete Membran wird beidseitig optisch ausgelesen. Alternativ kann die Membran entfallen und die ferroelektrische Schicht als Membran ausgebildet sein.

Die gestrichelten Linien in den Figuren für die Membran 21 sowie die Detektorschicht 22 geben ihren aus der Nullstellung ausgelenkten Zustand nach Druckbelastung D an.

In den Figuren sind schematisch die grundlegenden Elemente des Druck bzw. Zugsensors mit einer optischen Auslesung, umfassend die Membranhalterung 23 der Membran 21 und der Sensorschicht 22, gezeigt. Die gestrichelte Linie deutet den ausgelenkten Zustand der Membran mit der Sensorschicht auf Grund eines Druckes D an. Die gestrichelten Pfeile beschreiben den optischen Strahl zur optischen Auslesung, z. B. mittels Ellipsometrie. Die Membran kann für mikroskopische Messungen laterale Abmessungen von einigen Mikrometern bis hin zu einigen Zentimetern für nichtortsaufgelöste hoch empfindliche Messungen besitzen. Die Dicke der Membran 21 kann im Bereich von 10 $\mu$m gewählt werden. Die Dicke der Sensorschicht beträgt typischerweise 200 nm. Hier ist es auch denkbar, ohne das Trägersubstrat 21 zu arbeiten, z. B. bei Verwendung einer ausreichend dicken Sensorschicht (2 $\mu$m), bei deren Verbiegung die Kristallstruktur an Oberseite und Unterseite entgegengesetzt verspannt werden und durch die optische Auslesung lediglich eine der beiden Oberflächen erfasst wird.

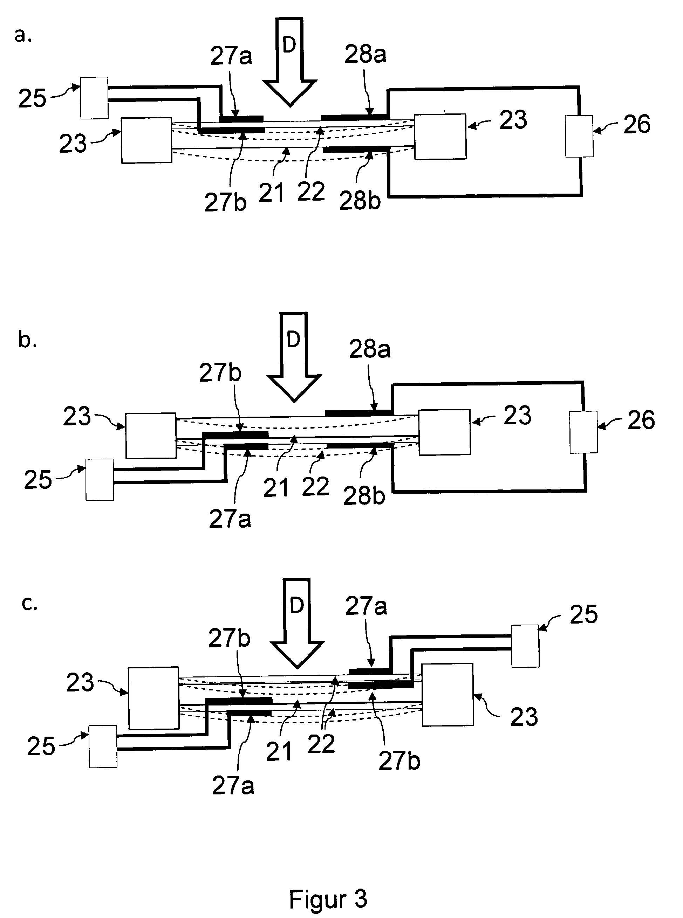

Figur 3 zeigt den Drucksensor mit kapazitiver Auslesung mittels Plattenkondensatoranordnung zur Bestimmung der normalen Polarisierung der ferroelektrischen Schicht. Der Plattenkondensator besteht jeweils aus Elektroden 27 bzw. 28 und der elektronisch angeschlossenen Ausleseelektronik 26. Folgende Fälle sind gezeigt:

a) Ferroelektrische Schicht auf der dem Druck (D>0) zugewandten Seite der Membran, mit einem nur die ferroelektrische Schicht umfassenden Elektrodenpaar 27 und einem die ferroelektrische Schicht und die Membran umfassenden Elektrodenpaar 28.

b) Ferroelektrische Schicht unter der dem Druck (D>0) zugewandten Seite der Membran, mit einem nur die ferroelektrische Schicht umfassenden Elektrodenpaar 27 und einem die ferroelektrische Schicht und die Membran umfassenden Elektrodenpaar 28.

c) Doppelseitige Auslesung einer doppelseitig mit ferroelektrischen Sensorschichten beschichteten Membran mittels zwei nur die ferroelektrische Schicht umfassenden Elektrodenpaaren 27a, 27b, wobei ein Elektrodenpaar an der oberen Schicht misst, während das zweite Elektrodenpaar an der unteren Schicht misst.

Figur 3 zeigt die schematische Darstellung der Sensoranordnung im Schnitt, bestehend aus Träger, hier als einer Membran 21 für Druckmessungen, ferroelektrischer Perowskitschicht 22 als Detektorschicht, eine ringförmige Halterung 23 als Trägersubstrat für die Schichten 21, 22 wie in Figur 2, allerdings mit kapazitiven Ausleseelektroden 27a, 27b, 28a, 28b und eine kapazitive Ausleseelektronik 25, 26.

Die Änderung der Permittivität kann somit auch kapazitiv ausgelesen werden, wie in den Figuren gezeigt. Hierzu kann eine Parallelplattenkapazitätenanordnung gewählt werden. Die Polarisierbarkeit der Detektorschicht 22 wird normal zum Trägersubstrat 21 bzw. zur Membranebene bestimmt.

Pfeil D gibt wiederum den auf das Trägersubstrat 21 und die Detektorschicht 22 wirkenden Druck an. Links des Pfeils D ist ein Parallelplattenkondensator 27a, 27b gezeigt, bei der die Elektroden lediglich die Detektorschicht umfassen, rechts davon ist ein Parallelplattenkondensator 28a, 28b gezeigt, bei dem die beiden Elektroden Membran bzw. Trägersubstrat 21 und die Sensorschicht als ferroelektrische Schicht 22 umfassen. Da im rechten Fall die dielektrischen Eigenschaften von Trägersubstrat und ferroelektrischer Sensorschicht vermessen werden, muss hier gewährleistet werden, dass die Permittivität und insbesondere Permittivitätsänderung bei Verbiegung vernachlässigbar klein sind. Beide Strukturen sind in Kombination wie gezeigt, oder auch einzeln möglich.

Die parallel angeordneten Platten 27a, 27 b sowie 28a, 28b bilden dabei die Kapazitäten C aus:

$$C = \varepsilon_o \varepsilon \frac{A}{d} \qquad \text{(Gleichung 1)}$$

wobei $\varepsilon_0$ = 8,85 · 10$^{-12}$ [As/Vm] die elektrische Feldkonstante, $\varepsilon$ die dielektrische Konstante oder Permittivität des Mediums zwischen den Platten, $A$ und $d$ die Fläche bzw. den Abstand der Platten bezeichnet. Generell gilt somit für diese Anordnungen sowie für die planaren Anordnungen der Elektroden auf der Detektorschicht

$$C \propto \varepsilon. \qquad \text{(Gleichung 2)}$$

Die höheren Empfindlichkeiten werden grundsätzlich mittels Verlängerung des effektiven Spaltes durch Verwendung von interdigitalen Strukturen 30a, 30b erzielt.

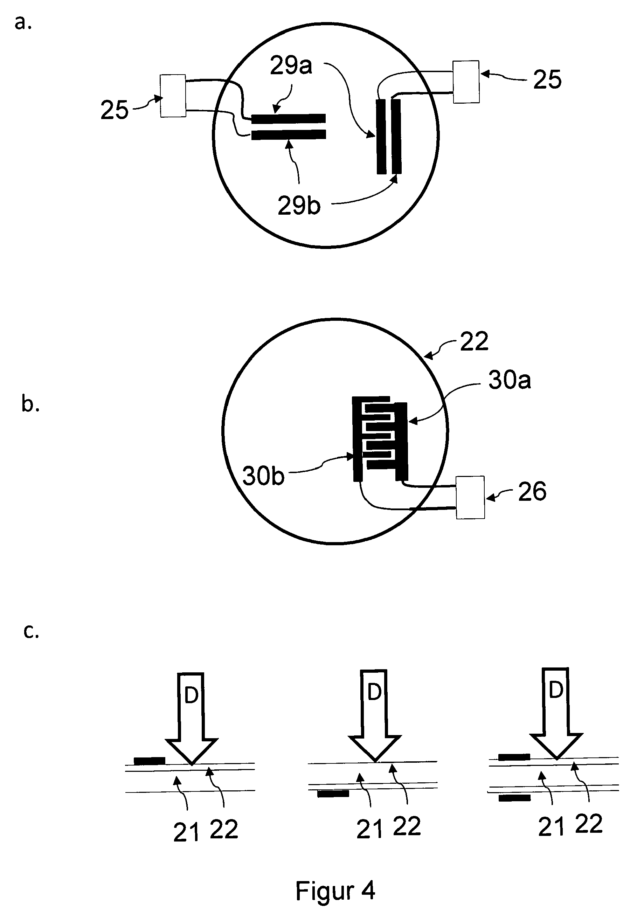

Figur 4 zeigt in Aufsicht (in (a) und (b)) unterschiedliche kapazitive Auslesekapazitäten zur Bestimmung der planaren Polarisierbarkeit, das heißt der Permittivität in der Schichtebene. Die Elektrodenpaare sind jeweils auf der ferroelektrischen Sensorschicht aufgebracht. Auch hier kann die Membran als Träger entfallen.

a) Planare Parallelplattenanordnung in Standardausführung.

b) Planare Interdigitalstruktur, mit der höhere Auflösungen auf kleineren Messflächen erzielt werden.

c) Unterschiedliche Messanordnungen in der Queransicht zeigt die mögliche Positionierung der planaren Elektrodenpaare.

Von links:

Planares Elektrodenpaar auf der ferroelektrischen Schicht, die ihrerseits auf der Membran angebracht ist, bestimmt die planare Dehnung/Stauchung der ferroelektrischen Schicht unterhalb der Membran.

Planares Elektrodenpaar unter der ferroelektrischen Schicht, die ihrerseits unter der Membran angebracht ist, bestimmt die planare Dehnung/Stauchung der ferroelektrischen Schicht oberhalb der Membran. Hierbei können gleichzeitig Dehnung und Stauchung in den Schichten oberhalb und unterhalb der Membran bestimmt werden.

Mit planaren Strukturen wird vorteilhaft die Permittivität der Detektorschicht 22 in der Schichtebene gemessen. Je nach Anwendungsziel können somit unterschiedliche Kapazitätsstrukturen verwendet werden, z. B. die Standardstrukturen bestehend aus zwei parallel angeordneten Streifen 29a, 29b mit minimalen Abstand oder interdigitalen Strukturen 30a, 30b mit erhöhter Kapazität. Hierbei können durch die Ausrichtung der Kapazitätsstrukturen die Permittivität und damit die Verbiegung in unterschiedlichen Richtungen separat bestimmt werden. Die planaren Anordnungen bestimmen die Permittivität lediglich in der Richtung, die durch die Elektroden vorgegeben wird. Diese Anordnung eignet sich somit zur Messung der Verbiegung der Membran mit Sensorschicht in eine durch die Elektrodenstruktur vorgegebene Richtung. In dieser Anordnung funktioniert der Sensor daher auch als Verbiegungssensor. Durch unterschiedliche Anordnung der Kapazitätsstrukturen lässt sich nun die Verbiegung der Membran mit Sensorschicht in unterschiedliche Richtungen detektieren.

Generell kann durch Miniaturisierung der Kapazitätsstrukturen, die lokale Veränderung der Durchbiegung bestimmt werden. Ferner können durch zeitliche Datenerfassung auch dynamische lokal aufgelöste Prozesse erfasst werden (z. B. für Touchscreens).

Die Sensoranordnung wird wie folgt hergestellt.

Als Trägermaterial 21 wird ein Si-Träger verwandt, in dem durch Ätzen ein Bereich auf ca. 2-5 $\mu$m gedünnt wird, so dass auf einer runden Fläche mit ca. 10 mm Durchmesser eine dünne, flexible Membran entsteht. Der Wafer wird nun mittels Magnetronkathodenzerstäubung auf der planen Seite mit einer dünnen kristallinen ferroelektrischen Schicht aus $SrTiO_3$ versehen. Die Schichtdicke der $SrTiO_3$-Schicht beträgt ca. 50 nm. Auf diese Schicht wird nun in Dünnschichttechnologie mittels Lift-off-Verfahren und Gold-Verdampfung ein Elektrodenpaar nebst Zuleitungen für die kapazitive Messung angebracht. Die Elektroden für die kapazitive Messung der Permittivität befinden sich auf der Membran, die Zuleitungen von den Elektroden führen zu den Kontakten zur Messelektronik 25, 26 außerhalb der Membran. Die Elektroden bestehen aus 8 mm x 1 mm großen Rechtecken, deren lange Kanten parallel zueinander angeordnet sind und einen Spalt von 2 $\mu$m bilden.

Der Si-Wafer wird vakuumdicht an eine Golay-Zelle angebracht. Über die außerhalb der Membran liegenden Zuleitungen wird nun mittels eines LC-Meters die Kapazität der kapazitiven Anordnung auf der Membran bestimmt. Änderungen der Temperatur in der Golay-Zelle bewirken eine Druckänderung im Inneren der Zelle, die zu einer Auslenkung der Si-Membran 21 führt. Die durch die Auslenkung der Membran bewirkte Änderung der Permittivität der $SrTiO_3$ verursacht nun eine Änderung der Kapazität. Die Änderung der Temperatur in der Golay-Zelle wird so in eine leicht messbare Änderung der Kapazität überführt.

Eine Durchbiegung der Trägerschicht 21 und der Detektorschicht 22 auf Grund einer Druckänderung D schlägt somit immer auf die Kondensatoranordnung 27a, 27b nebst Messelektronik 25 bzw. 28a, 28b und 26 sowie 29a, 29b und 30a, 30b durch. Kapazitäten vom pF-Bereich bis in den $\mu$F-Bereich können auf diese Weise ausgelesen werden.

**Patentansprüche**

1. Sensoranordnung, umfassend ein Trägersubstrat sowie eine auf dem Trägersubstrat angeordnete ferroelektrische Schicht, wobei die ferroelektrische Schicht kristallin auf dem Trägersubstrat angeordnet ist,
   **dadurch gekennzeichnet,**
   **dass** die Sensoranordnung Mittel zum Auslesen der Permittivität der ferroelektrischen Schicht aufweist, und die Anordnung dazu ausgelegt ist, einen auf die ferroelektrische Schicht wirkenden mechanischen Druck durch die resultierende Änderung und Messung der Permittivität des ferroelektrischen Materials nachzuweisen.

2. Sensoranordnung nach vorherigem Anspruch,
   **gekennzeichnet durch**
   ein flexibles Trägersubstrat.

3. Sensoranordnung nach einem der vorhergehenden Ansprüche,
   **gekennzeichnet durch**
   Silizium oder $Al_2O_3$, oder Polyimid oder ein Metall als Material des Trägersubstrats.

4. Sensoranordnung nach vorherigem Anspruch
   **gekennzeichnet durch**
   ein ferroelektrisches Material aus $CaTiO_3$, $SrTiO_3$, $KTaO_3$, $BaTiO_3$, $Pb_5GeO_{11}$, $Eu_2(MoO_4)_3$, $PbTa_2O_6$, $KNbO_3$, $SrTeO_3$, $PbTiO_3$, $SrBi_2Ta_2O_9$, $LiTaO_3$, $LiNbO_3$ oder einer Kombination dieser Materialien.

5. Sensoranordnung nach einem der vorhergehenden Ansprüche,
   **dadurch gekennzeichnet, dass**
   eine ferroelektrische Schicht aus Material mit einer Übergangstemperatur kleiner der Raumtemperatur auf dem Trägersubstrat angeordnet ist, so dass sich ein Druck zu einer Zugspannung auf das Kristallgitter der ferroelektrischen Schicht auswirkt.

6. Sensoranordnung nach einem der vorhergehenden Ansprüche,
   **dadurch gekennzeichnet, dass**
   ein ferroelektrisches Material mit einer Übergangstemperatur größer der Raumtemperatur auf dem Trägersubstrat angeordnet ist, so dass sich ein Druck zu einer Druckspannung auf das Kristallgitter auswirkt.

**7.** Sensoranordnung nach einem der vorhergehenden Ansprüche,
**dadurch gekennzeichnet, dass**
ein ferroelektrisches Material mit einer Übergangstemperatur größer der Raumtemperatur auf einer Seite des Trägersubstrats und ein ferroelektrisches Material mit einer Übergangstemperatur kleiner der Raumtemperatur auf der gegenüberliegenden Seite des Trägersubstrats angeordnet ist.

**8.** Verfahren zur Herstellung einer Sensoranordnung nach einem der vorhergehenden Ansprüche,
in dem ein ferroelektrisches Material kristallin durch physikalische Gasphasenabscheidung, chemische Gasphasenabscheidung, chemische Abscheidung aus der Lösung oder elektrophoretische Abscheidung auf einem Trägersubstrat angeordnet wird,
**dadurch gekennzeichnet, dass** Mittel angeordnet werden, welche dazu ausgelegt sind, einen auf die ferroelektrische Schicht wirkenden mechanischen Druck durch die resultierende Änderung und Messung der Permittivität des ferroelektrischen Materials nachzuweisen.

**9.** Verwendung einer Sensoranordnung nach einem der vorhergehenden Ansprüche, als Druck- oder Biegesensor, bei dem eine normal auf die Sensoranordnung ausgeübte mechanische Kraft reversibel eine Änderung der Polarisierbarkeit in der ferroelektrischen Schicht hervorruft, und nach Abklingen der Kraft die Polarisierbarkeit der ferroelektrischen Schicht wieder in den Ausgangszustand überführt wird.

**10.** Verwendung nach vorherigem Anspruch
**gekennzeichnet durch**
Messung des Drucks bei der Übergangstemperatur der ferroelektrischen Schicht.


**Claims**

**1.** Sensor arrangement, comprising a carrier substrate and a ferroelectric layer arranged on the carrier substrate, in which the ferroelectric layer is arranged on the carrier substrate in a crystalline way,
**characterised in that**
the sensor arrangement has means to reading the permittivity of the ferroelectric layer and the arrangement is designed to detect a mechanical pressure acting on the ferroelectric layer through the resulting change and measurement of the permittivity of the ferroelectric material.

**2.** Sensor arrangement according to the previous claim,
**characterised by**
a flexible carrier substrate.

**3.** Sensor arrangement according to one of the previous claims,
**characterised by**
silicon or $Al_2O_3$ or a polyimide or a metal as the material of the carrier substrate.

**4.** Sensor arrangement according to the previous claim,
**characterised by**
a ferroelectric material made of $CaTiO_3$, $SrTiO_3$, $KTaO_3$, $BaTiO_3$, $Pb_5GeO_{11}$, $Eu_2(MoO_4)_3$, $PbTa_2O_6$, $KNbO_3$, $SrTeO_3$, $PbTiO_3$, $SrBi_2Ta_2O_9$, $LiTaO_3$, $LiNbO_3$ or a combination of these materials.

**5.** Sensor arrangement according to one of the previous claims,
**characterised in that**
a ferroelectric layer made of material with a transition temperature that is lower than room temperature is arranged on the carrier substrate so that a pressure has the effect of producing tensile stress on the crystal lattice of the ferroelectric layer.

**6.** Sensor arrangement according to one of the previous claims,
**characterised in that**
a ferroelectric material with a transition temperature that is higher than room temperature is arranged on the carrier substrate so that a pressure has the effect of producing compressive stress on the crystal lattice.

**7.** Sensor arrangement according to one of the previous claims,

**characterised in that**
a ferroelectric material with a transition temperature that is higher than room temperature is arranged on one side of the carrier substrate and a ferroelectric material with a transition temperature that is lower than room temperature is arranged on the opposite side of the carrier substrate.

8. Method for producing a sensor arrangement according to one of the previous claims, in which a ferroelectric material is arranged on a carrier substrate in a crystalline way through physical gas phase deposition, chemical gas phase deposition, chemical deposition from solution or electrophoretic deposition, **characterised in that** means are arranged, which are designed to detect a mechanical pressure acting on the ferroelectric layer through the resulting change and measurement of the permittivity of the ferroelectric material.

9. Use of a sensor arrangement according to one of the previous claims as a pressure or bending sensor, in which a mechanical force applied to the sensor arrangement in a normal way causes a change in the polarisability of the ferroelectric layer in a reversible way and after the force has subsided the polarisability of the ferroelectric layer is returned to the original state.

10. Use according to the previous claim,
**characterised by**
measuring the pressure at the transition temperature of the ferroelectric layer.

**Revendications**

1. Ensemble de capteur, comprenant un substrat de support ainsi qu'une couche ferroélectrique disposée sur le substrat de support, sachant que
la couche ferroélectrique est disposée de manière cristalline sur le substrat de support,
**caractérisé en ce**
**que** l'ensemble de capteur présente des moyens servant à lire la permittivité de la couche ferroélectrique, et en ce que l'ensemble est configuré
afin de démontrer une pression mécanique agissant sur la couche ferroélectrique par la modification et la mesure en résultant de la permittivité du matériau ferroélectrique.

2. Ensemble de capteur selon la revendication précédente,
**caractérisé par**
un substrat de support flexible.

3. Ensemble de capteur selon l'une quelconque des revendications précédentes,
**caractérisé par**
du silicium ou du $Al_2O_3$ ou du polyimide ou un métal en tant que matériau du substrat de support.

4. Ensemble de capteur selon la revendication précédente,
**caractérisé par**
un matériau ferroélectrique composé de $CaTiO_3$, $SrTiO_3$, $KTaO_3$, $BaTiO_3$, $Pb_5GeO_{11}$, $Eu_2(MoO_4)_3$, $PbTa_2O_6$, $KNbO_3$, $SrTeO_3$, $PbTiO_3$, $SrBi_2Ta_2O_9$, $LiTaO_3$, $LiNbO_3$ ou une combinaison desdits matériaux.

5. Ensemble de capteur selon l'une quelconque des revendications précédentes,
**caractérisé en ce**
**qu'**une couche ferroélectrique composée d'un matériau présentant une température de transition inférieure à la température ambiante est disposée sur le substrat de support de sorte qu'une pression exerce un impact, aux fins d'une tension de traction, sur le réseau cristallin de la couche ferroélectrique.

6. Ensemble de capteur selon l'une quelconque des revendications précédentes,
**caractérisé en ce**
**qu'**un matériau ferroélectrique présentant une température de transition supérieure à la température ambiante est disposé sur le substrat de support de sorte qu'une pression exerce un impact, aux fins d'une tension de pression, sur le réseau cristallin.

7. Ensemble de capteur selon l'une quelconque des revendications précédentes,

**caractérisé en ce**

**qu'**un matériau ferroélectrique présentant une température de transition supérieure à la température ambiante est disposé sur un côté du substrat de support, et en ce qu'un matériau ferroélectrique présentant une température de transition inférieure à la température ambiante est disposé sur le côté opposé du substrat de support.

**8.** Procédé servant à fabriquer un ensemble de capteur selon l'une quelconque des revendications précédentes, dans lequel

un matériau ferroélectrique est disposé, à l'état cristallin, par un dépôt physique en phase gazeuse, par un dépôt chimique en phase gazeuse, par un dépôt chimique à partir de la solution ou par un dépôt électrophorétique, sur un substrat de support,

**caractérisé en ce que** sont disposés des moyens qui sont configurés pour démontrer une pression mécanique agissant sur la couche ferroélectrique par la modification et la mesure en résultant de la permittivité du matériau ferroélectrique.

**9.** Utilisation d'un ensemble de capteur selon l'une quelconque des revendications précédentes en tant que capteur de pression ou de flexion, dans lequel une force mécanique exercée de manière normale sur l'ensemble de capteur provoque de manière réversible une modification de la polarisabilité dans la couche ferroélectrique et où après l'atténuation de la force, la polarisabilité de la couche ferroélectrique est ramenée à nouveau dans l'état de départ.

**10.** Utilisation selon la revendication précédente,

**caractérisée par**

la mesure de la pression à la température de transition de la couche ferroélectrique.

Figur 1

a.

b.

c.

Figur 2

Figur 3

a.

29a

25

25

29b

b.

22

30a

30b

26

c.

D D D

21 22    21 22    21 22

Figur 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0661754 A

**In der Beschreibung aufgeführte Nicht-Patentliteratur**

- **R. WÖRDENWEBER ; E. HOLLMANN ; R. OTT ; T. HÜRTGEN ; KAI KEONG LEE.** Improved ferroelectricity of strained SrTiO3 thin films on sapphire. *J Electroceram,* 2009, vol. 22, 363-368